# EUROPEAN PATENT SPECIFICATION

(11) **EP 1 617 655 B1**
(45) Date of publication and mention of the grant of the patent: **29.07.2009**
(21) Application number: 04728420.3
(22) Date of filing: 20.04.2004
(51) Int. Cl.: H04N 5/335, H01L 27/146, H01L 31/0203

(54) **IMAGING DEVICE AND MOBILE TERMINAL USING THIS IMAGING DEVICE**
ABBILDUNGSEINRICHTUNG UND MOBILES ENDGERÄT MIT DIESER ABBILDUNGSEINRICHTUNG
DISPOSITIF D'IMAGERIE ET TERMINAL MOBILE COMPORTANT UNE TEL DISPOSITIF

(30) Priority: 22.04.2003 JP 2003116949
(43) Date of publication of application: 18.01.2006
(73) Proprietor: Konica Minolta Opto, Inc., Hachioji-shi, Tokyo 192-8505 (JP)
(72) Inventor: NISHIKAWA, Takuo, c/o KONICA MINOLTA OPTO, INC., 1928505 (JP); TANSHO, Kazuo, c/o KONICA MINOLTA OPTO, INC., 1928505 (JP)
(74) Representative: Henkel, Feiler & Hänzel
(86) International application number: PCT/JP2004/005601
(87) International publication number: WO 2004/095832

(56) References cited:
- JP-A- 7 299 883
- JP-A- 2001 292 378
- JP-A- 2002 077 683
- US-A1- 2001 055 073
- US-A1- 2002 044 213
- US-A1- 2002 047 119

## Description

### Background Art:

The present invention relates to an imaging unit which can be mounted on a compact portable terminal equipment such as a cellular phone set or mobile computer and a portable terminal equipment mounting the imaging unit.

### Prior Art:

Compact, flat imaging units have recently been developed and mounted in compact, flat electronic devices such as cellular phone sets and personal computers. With further downsizing of cellular phone sets and computers mounting such imaging units, attempts have been made to downsize imaging units as well, and various kinds of proposals have been made.

For example, there is known a technique of implementing an imaging unit having a small total thickness by forming an opening portion at a predetermined position on a circuit board, mounting an imaging element on one side of the circuit board by a so-called flip-chip mounting method so as to cover the opening portion, and providing an outer frame member having an optical member on the other side of the circuit board so as to oppose the imaging element through the opening portion (see, for example, Japanese Unexamined Patent Publication No. 2001-292354).

In addition, there is known a technique in which when an imaging element is to be flip-chip mounted on a flexible printed circuit board, a metal plate made of a stainless steel plate is bonded on the flexible printed circuit board with an adhesive or the like to ensure the strength of the circuit board (see, for example, Japanese Unexamined Patent Publication No. 2001-128072 (the right column of page 3 and Figs. 2 and 3)).

The flip-chip mounting method disclosed in Japanese Unexamined Patent Publication No. 2001-292354 is a method effective in reducing the profile of an imaging unit because the thickness of the circuit board does not contribute to the total thickness of the imaging unit.

In this flip-chip mounting method, protruding electrodes (bumps) formed on the electrode pads of an imaging element are connected to electrodes on a printed circuit board. As connection methods for this technique, for example, ACF (Anisotropic Conductive Film), ACP (Anisotropic Conductive Paste), solder bump, and gold-tin eutectic connection methods are used as well as joining by ultrasonic welding (to be referred to as ultrasonic welding hereinafter) .

In this mounting method, when a flexible printed circuit board is used, the following problem occurs. When a torsional force or the like is applied to the circuit board as it is mounted in a portable terminal equipment, since the circuit board is flexible, a connection portion may peel off or the imaging optical system may become unstable. In order to solve this problem, a reinforcing plate is attached to the flexible printed circuit board. Document US-A-2001/0055073 discloses an images mounted on a flexible circuit board.

The following problem, however, arises in the arrangement disclosed in Japanese Unexamined Patent Publication No. 2001-128072, i.e., the arrangement in which an imaging element is flip-chip mounted on one side of a flexible printed circuit board, and a stainless steel plate is bonded as a reinforcing plate on the other side.

When a semiconductor device is mounted on a circuit board, it is unavoidable that the entire circuit board is exposed to a high temperature or locally heated to a high temperature. Assume that the circuit board is passed through a high-temperature atmosphere to melt solder paste or ultrasonic welding is performed. In this case, the stainless steel plate, flexible printed circuit board, and imaging element are heated to a temperature of about 100°C to 130°C and cooled to room temperature again. This applies a very high thermal shock load onto each portion constituting the mounting circuit board.

In addition to this, a thermal shock load occurs even after the imaging unit is mounted in the portable terminal equipment. When, for example, the portable terminal equipment is exposed to direct sunlight in a car under the scorching sun, the portable terminal equipment is heated up to about 80°C. When the portable terminal equipment is in the open air in the middle of winter, the equipment is cooled below the freezing point. In an actual operating environment, such a phenomenon repeatedly occurs.

For this reason, in consideration of these problems, various tests have been conducted to check and guarantee reliability against thermal shocks.

In such a case, on a flexible printed circuit board to which a connected imaging element and a stainless steel plate as a reinforcing member are bonded, an electrode pad of the connected imaging element or an electrode on the circuit board may peel off, and a solidified bump may crack. In the worst case, a fracture occurs to result in breaking the connection.

The present invention has been made in consideration of the above problems of the prior art, and has as its object to provide an imaging unit which is free from a failure such as disconnection and high in reliability and durability against thermal shocks applied to the imaging unit having an imaging element flip-chip mounted on one side of a flexible printed circuit board with a reinforcing member being bonded on the other side of the circuit board.

### Disclosure of Invention:

In order to achieve the above object, according to the first aspect of the present invention, there is provided an imaging unit mounted on a compact portable terminal equipment as recited in claim 1. Further advantageous embodiments are recited in the dependent claims.

According to the second aspect of the present invention, there is provided a portable terminal equipment characterized by mounting an imaging unit defined in any one of the above described aspects.

As is obvious from each aspect described above, according to the present invention, operation of selecting and using a material having the above linear expansion coefficient as a reinforcing member for a flexible printed circuit board on which an imaging element is flip-chip mounted makes it possible to obtain an imaging unit with high durability which can endure thermal shocks applied to the imaging unit when the imaging element is connected, by flip-chip mounting, to the flexible printed circuit board to which the reinforcing member is bonded and thermal shocks applied to the imaging unit when the unit is used after being incorporated in a portable terminal equipment. In addition, using this imaging unit makes it possible to obtain a portable terminal equipment with high durability.

As described above, the present inventors have found that when an imaging unit is connected to a flexible printed circuit board by flip-chip mounting, only making a reinforcing member have a function of maintaining strength cannot prevent a problem from occurring due to thermal shocks, and the cause of the problem is associated with the thermal expansion of the imaging element and flexible printed circuit board. Therefore, a material with a small linear expansion coefficient is used as a reinforcing member to obtain a structure which can ensure thermal shocks by suppressing the thermal expansion of a flexible printed circuit board with a large linear expansion coefficient, thereby ensuring connection between the imaging element and the flexible printed circuit board.

The above and other objects, features, and advantages of the present invention will become manifest to those skilled in the art upon making reference to the following detailed description and accompanying drawings in which a preferred specific example coinciding with the principle of the present invention is shown as an embodiment.

Obviously, the present invention is described in the following detailed description, and is not limited to the embodiment shown in the accompanying drawings, but only by the appended claims.

### Brief Description of Drawings:

Figs. 1A and 1B are perspective views showing the main part of an imaging unit according to the present invention, in which Fig. 1A is a view taken from the light incident side, and Fig. 1B is a view taken from the opposite side;
Fig. 2 is a fragmentary sectional view taken along a line II - II in Fig. 1;
Fig. 3 is a fragmentary plan view of a flexible printed circuit board of the imaging unit;
Figs. 4A to 4C are views each for explaining a schematic sequence for assembling the imaging unit according to the present invention; and
Figs. 5A and 5B are a schematic front view and schematic rear view, respectively, showing an example of a portable terminal equipment mounting the imaging unit according to the present invention.

### Best Mode for Carrying Out the Invention:

A best mode for carrying out the present invention will be described in detail with reference to the accompanying drawings.

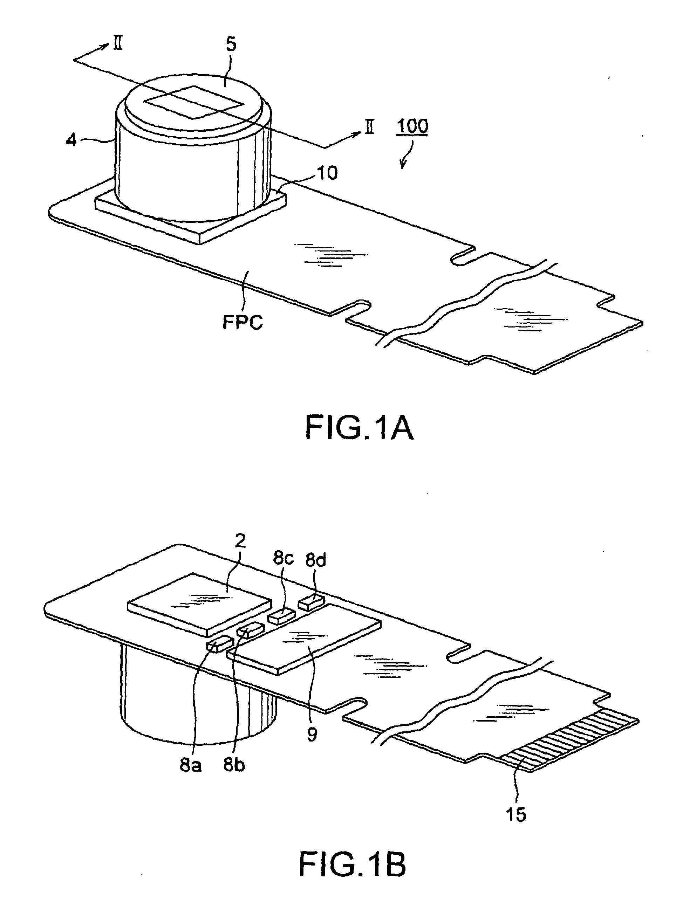

Figs. 1A and 1B are respectively a perspective view of the upper surface of an imaging unit 100 viewed from the light incident side and a perspective view of the lower surface of the imaging unit 100 viewed from the imaging element side.

As shown in Figs. 1A and 1B, the upper surface of the imaging unit 100 is provided with a flexible printed circuit board FPC based on, for example, polyimide, a light-shielding plate 5 having an opening portion for the entrance of light to the flexible printed circuit board FPC, an outer frame member 4 enclosing an optical member and the like, and a reinforcing plate 10 as a reinforcing member. The lower surface of the imaging unit 100 is provided with an imaging element 2 electrically connected to the other surface of the flexible printed circuit board FPC by clip-chip mounting. In addition, electronic circuit components 8a to 8d and 9 and the like for driving the imaging element 2 are mounted on the flexible printed circuit board FPC, and a connection terminal portion 15 for connection to a control circuit board and the like is provided on an end portion.

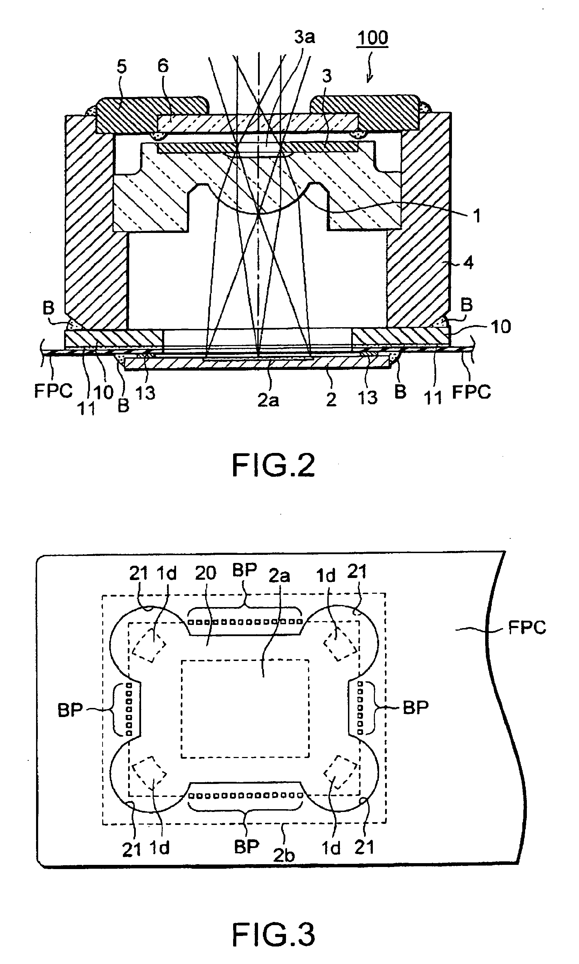

Fig. 2 is a fragmentary sectional view of the imaging unit 100 taken along a line II - II in Fig. 1.

As shown in Fig. 2, the imaging unit 100 is comprised of an optical member 1, an aperture plate 3 having an aperture portion 3a, and an infrared cut filter 6 in addition to the above flexible printed circuit board FPC, imaging element 2, outer frame member 4, light-shielding plate 5, and reinforcing plate 10.

Referring to Fig. 2, the imaging element 2 comprises, for example, a CMOS (Complementary Metal-Oxide Semiconductor) type image sensor, CCD (Charge Coupled Device) type image sensor, or the like, and is attached to the flexible printed circuit board FPC such that a photoelectric conversion unit 2a of the imaging element 2 is exposed through an opening portion of the flexible printed circuit board FPC. The bonding pads (not shown) formed on the flexible printed circuit board FPC are electrically connected to protruding electrodes (bumps) 13 formed on the electrode pads of the imaging element 2 by ultrasonic welding, and the outer periphery of the imaging element 2 is fixed with an adhesive B.

These bumps are formed by a forming method called the stud bump method (or ball bump method). Other than this forming method, however, for example, a bump forming method using a plating method, transfer bump method, or soldering technique can be used.

The reinforcing plate 10 is fixed on the flexible printed circuit board FPC with an adhesive layer 11. The optical member 1 and outer frame member 4 are mounted on the reinforcing plate 10. In addition, the light-shielding plate 5 to which the infrared cut filter 6 is bonded is mounted on the reinforcing plate 10. The aperture plate 3 having the aperture portion 3a is attached to the optical member 1.

Note that leg portions may be integrally formed on the optical member 1 at positions other than the optical effective surface, and the leg portions may be brought into contact with portions of the flexible printed circuit board FPC other than the photoelectric conversion unit 2a of the imaging element 2 through the opening portion of the flexible printed circuit board FPC and pressed against the imaging element 2 side with elastic members. This makes it possible to set a constant interval between the photoelectric conversion unit 2a and the optical effective surface of the optical member and to eliminate the necessity of the focus adjustment of the optical member.

Fig. 3 is a fragmentary front view of the flexible printed circuit board FPC of the imaging unit 100. Fig. 3 is a view taken from the surface side on which the imaging element 2 (see Fig. 2) is attached. The flexible printed circuit board FPC has a pattern surface on the surface side on which the imaging element is attached.

As shown in Fig. 3, an opening portion 20 is formed in the flexible printed circuit board FPC. Notched portions 21 are formed at the four corners of the opening portion 20 to disperse the stress caused by the expansion or contraction of the flexible printed circuit board FPC due to a change in temperature, thereby suppressing the deformation or distortion of the flexible printed circuit board FPC. This makes it possible to ensure the reliability of electrical connection between the flexible printed circuit board FPC and the imaging element. Bonding pads BP for electrical connection are arranged on the inner edge portion of the flexible printed circuit board FPC which faces the opening portion 20 at positions corresponding to the input/output terminals of the imaging element. The bonding pads BP comprise, for example, copper, nickel, tin, silver, gold, palladium, an alloy thereof, or a multilayer made of these metals.

The opening portion 20 of the flexible printed circuit board FPC is formed larger than a range corresponding to the photoelectric conversion unit 2a which converts incident light into an electrical signal. Note that the rectangular portion denoted by reference numeral 2b in Fig. 3 indicates the outer frame position of the overall imaging element when the imaging element 2 is attached to the flexible printed circuit board FPC. Reference numerals 1d shown inside the notched portions 21 inside the outer frame 2b of the overall imaging element denote examples of the abutment positions of the leg portions (not shown) of the optical member 1 when the leg portions are designed to abut against the imaging element 2.

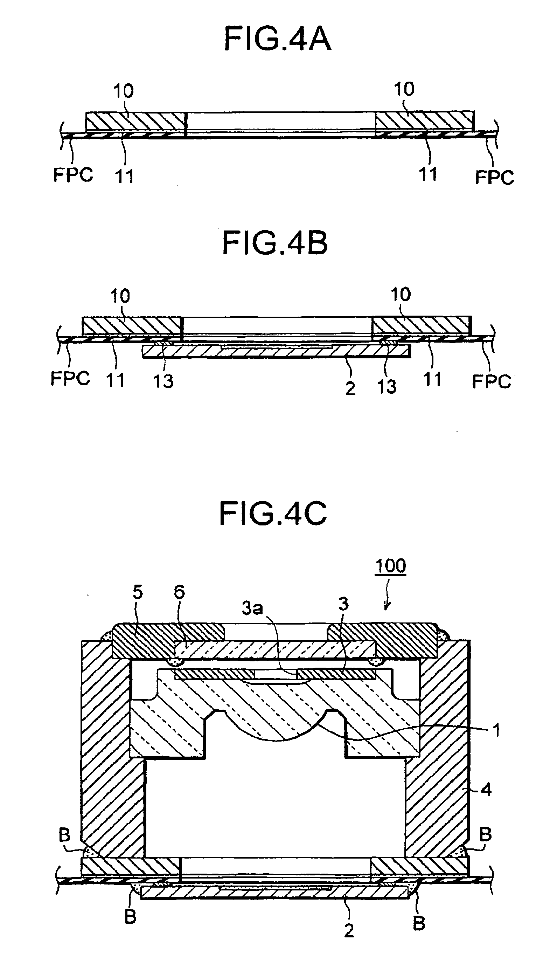

Figs. 4A to 4C are views each for explaining a schematic sequence for assembling the imaging unit 100 of the present invention.

First of all, as shown in Fig. 4A, the flexible printed circuit board FPC and reinforcing plate 10 are fixed to each other with the adhesive layer 11.

For the reinforcing plate 10, one of the following materials each having a linear expansion coefficient of 1 x 10⁻⁵ (cm/cm/°C) or less is used: 42 nickel alloy, 50Fe50Ni, 64Fe36Ni, ceramics, and glass. The ceramics includes, for example, alumina (Al₂O3) , aluminum nitride (AlN), zirconia (ZrO₃), boron nitride (BN), silicon carbide (SiC), silicon nitride (Si₃N₄), and sialon (a composite material of Si₃N₄ and Al₂O₃).

Note that the reinforcing plate 10 and linear expansion coefficient will be described in detail in the following experimental examples.

In addition, as the adhesive layer 11, a thermosetting adhesive, epoxy-based adhesive, or the like can be used. A thermosetting adhesive is preferably used in particular. In addition, for the flexible printed circuit board FPC, a so-called two-layer material of a two-layer material, three-layer material, and the like is preferably used.

The two-layer material in this case is obtained by, for example, forming a copper film having a thickness of about 0.3 µm on a polyimide base matrix by sputtering, further forming a copper layer thereon, and patterning the copper layer by etching (this forming method is called a metallizing method) or coating a copper base with a precursor of polyimide to imidize the base (this forming method is called a casting method). The three-layer material is obtained by, for example, bonding a polyimide base matrix to a copper foil with an adhesive and patterning the copper foil by etching.

When the above three-layer material is to be connected by ultrasonic welding (to be described later), since the adhesive material almost equal in thickness to the base matrix is flexible, ultrasonic vibrations are absorbed by the adhesive layer. This causes a problem that sufficient vibration energy cannot be transferred to bumps. This problem applies to the adhesive of the adhesive layer 11.

For this reason, according to the present invention, a two-layer material including no adhesive layer between a base matrix and copper is preferably used as the flexible printed circuit board FPC, and a thermosetting adhesive is preferably used as the adhesive layer 11 between the flexible printed circuit board FPC and the reinforcing plate 10. In addition, as the reinforcing plate 10, a material having a light-shielding effect is preferably used to prevent light from entering through portions other than the aperture portion 3a of the aperture plate 3.

Subsequently, as shown in Fig. 4B, the imaging element 2 is connected. As this connection, electrical connection is performed by, for example, ultrasonic welding.

It suffices to perform ultrasonic welding by a known method. For example, a tool with the following conditions:
frequency: 50 kHz, tool temperature: 150°C, temperature of
a support table: 100°C, joining time: 0.5 sec, tool
pressurizing force: 0.5 N per bump, and amplitude: 5 µm, is brought into contact with the reinforcing plate 10, and the bumps 13 formed on the electrode pads of the imaging element 2 are melted by vibration energy through the
reinforcing plate 10 and flexible printed circuit board FPC.
With this operation, the electrode pads of the imaging element 2 are connected to the bonding pads of the flexible printed circuit board FPC through the bumps 13.

Subsequently, as shown in Fig. 4C, the outer periphery of the imaging element 2 is sealed with the adhesive B. As a consequence, the optical member 1 incorporating the outer frame member 4 and aperture plate 3 and the light-shielding plate 5 incorporating the infrared cut filter 6 are mounted. The respective components are fixed to necessary portions with an adhesive, as needed.

The imaging unit 100 of the present invention is completed by the above sequence.

A portable terminal equipment mounting the above imaging unit of the present invention will be described next.

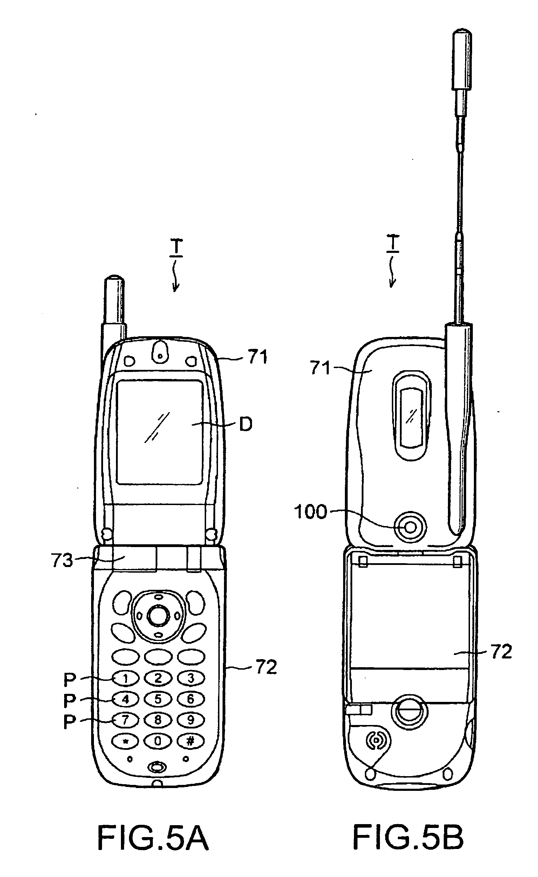

Figs. 5A and 5B are a schematic front view and schematic rear view showing an example of the portable terminal equipment mounting the imaging unit 100 of the present invention.

As shown in Figs. 5A and 5B, the portable terminal equipment is, for example, a foldable cellular phone set T (to be referred to as the cellular phone set T hereinafter). An upper housing 71 as a case having a display screen D is coupled to a lower housing 72 having operation buttons P through a hinge 73. The imaging unit 100 is incorporated in the upper housing 71 below the display screen D such that the optical member 1 of the imaging unit 100 can capture light from the outer surface side of the upper housing 71.

Incorporating the imaging unit 100 in the cellular phone set T makes it possible to obtain the cellular phone set T with high reliability against thermal shocks and the like. Note that the position of the imaging unit 100 is not limited to this. For example, the imaging unit 100 can be located above the display screen D in the upper housing 71. In addition, obviously, the cellular phone set is not limited to a foldable type.

In order to obtain a material suitable for the reinforcing plate 10 described above, the following experiments were conducted by using the following kinds of materials.

Each of reinforcing plates made of the materials written in Table 1 was bonded to a flexible printed circuit board, and an imaging element was flip-chip mounted on the circuit board. Thermal shocks were applied to the resultant structures. Post-experiment evaluations were then made.

### Experimental Example 1:

The following were the set conditions:
imaging element: CMOS type image sensor
chip size: 6.5 (mm) x 5 (mm)
bump: stud bump
connection terminal count: 42 (14 x 2 in longitudinal direction, 7 x 2 in transverse direction)
connection method: ultrasonic welding (under the following conditions):
   frequency: 50 kHz, tool temperature: 150°C,
   temperature of a support table: 100°C, joining
   time: 0.5 sec, tool pressurizing force: 0.5 N
   per bump, amplitude: 5 µm

Each imaging unit manufactured under the above conditions was left to stand in a store chamber at a temperature of 80°C for 30 min, and was then left to stand in the store chamber at -40°C for 30 min. These operations were alternately repeated 500 times. A continuity check was made in the imaging unit. This checking method was conducted by watching the image captured by the imaging unit used in the experiment. That is, it was checked by making use of a module whether the image was properly displayed.

### Experimental Example 2:

Each imaging unit manufactured under the same conditions as those in Experimental Example 1 was left to stand in a store room at a temperature of 125°C for 30 min, and was then left to stand in the store room at -40°C for 30 min. These operations were alternately repeated 500 times. A continuity check was made in the imaging unit in the same manner as in Experimental Example 1.

Table 1 shows the results obtained in Experimental Examples 1 and 2. Each of the above experiments was conducted with respect to 100 samples. If no continuity failure occurred in all the 100 samples, "o" was written in the table, whereas if a continuity failure occurred in even one sample, "X" was written in the table.

**Table 1**

| Sample No. | Material for Reinforcing Material | Linear Expansion Coefficient x 10⁻⁶ (cm/cm/°C) | Result of Experimenta 1 Example 1 | Result of Experimenta 1 Example 2 |
|---|---|---|---|---|
| 1 | 64Fe36Ni | 0.13 | ○ | ○ |
| 2 | 42 alloy | 5 | ○ | ○ |
| 3 | ceramics | 2 to 6 | ○ | ○ |
| 4 | glass | 2.8 to 9 | ○ | ○ |
| 5 | 50Fe50Ni | 9.4 | ○ | ○ |
| 6 | carbon steel | 10.7 | ○ | ○ |
| 7 | 65co25Cr10W | 11.2 | ○ | X |
| 8 | 18Cr8Ni | 14.7 | ○ | X |
| 9 | glass epoxy | 16 | ○ | X |
| 10 | aluminum | 23.1 | X | X |

It is obvious from the above experiment results that a material with a linear expansion coefficient of 10.7 x 10⁻⁵ (cm/cm/°C) or less is suitable as a material for a reinforcing plate.

## Claims

1. An imaging unit (100) mounted on a compact portable terminal equipment, **characterized by** comprising:
(a) a flexible printed circuit board (FPC) having an opening portion at a predetermined position;
(b) an imaging element (2) which is connected, by flip-chip mounting, to one side of said circuit board so as to cover at least part of the opening portion and expose an imaging area;
(c) a reinforcing member (10) attached to the other side of said circuit board to reinforce said circuit board;
(d) an optical member (1) which is provided to guide object light from a surface on the reinforcing member side to the imaging area of said imaging element through the opening portion; and
(e) an outer frame member (4) enclosing said optical member, **characterised in that** the reinforcing member is made of a non-metallic material having a linear expansion coefficient of 1×10⁻⁵(cm/cm/°c) or less.

2. An imaging unit according to claim 1, **characterized in that** the reinforcing member consisting of said non-metallic material is made of glass or ceramics.

3. An imaging unit according to claim 1, **characterized in that** when said reinforcing member is to be attached to said flexible printed circuit board, a thermosetting adhesive is used.

4. An imaging unit according to claim 1, **characterized in that** said flexible printed circuit board includes no adhesive layer between a base matrix and a copper layer.

5. An image unit according to claim 1, wherein notched portions (21) are founded in the opening portion of said flexible printed circuit board.

6. A portable terminal equipment **characterized by** mounting an imaging unit defined in claim 1.

## Patentansprüche

1. Abbildungseinheit (100), die an einem kompakten tragbaren Endgerät angebracht ist, **dadurch gekennzeichnet, dass** sie umfasst:
(a) eine flexible Leiterplatte (FPC), die an einer vorgegebenen Position einen Öffnungsbereich aufweist;
(b) ein Abbildungselement (2), das durch Flip-Chip-Montage mit einer Seite der Leiterplatte derart verbunden ist, dass mindestens ein Teil des Öffnungsbereichs bedeckt ist und ein Abbildungsbereich freiliegt;
(c) ein Verstärkungselement (10), das zur Verstärkung der Leiterplatte an der anderen Seite der Leiterplatte befestigt ist;
(d) ein optisches Element (1), das zur Führung von Licht eines Objekts von einer Oberfläche auf der Verstärkungselementseite zum Abbildungsbereich des Abbildungselements durch den Öffnungsbereich angebracht ist; und
(e) ein Außenrahmenelement (4), das das optische Element umschließt,
**dadurch gekennzeichnet, dass** das Verstärkungselement aus einem nichtmetallischen Material mit einem linearen Ausdehnungskoeffizienten von 1 x 10⁻⁵ (cm/cm/°C) oder weniger besteht.

2. Abbildungseinheit nach Anspruch 1, **dadurch gekennzeichnet, dass** das aus dem nichtmetallischen Material bestehende Verstärkungselement aus Glas oder Keramik besteht.

3. Abbildungseinheit nach Anspruch 1, **dadurch gekennzeichnet, dass**, wenn das Verstärkungselement an der flexiblen Leiterplatte befestigt werden soll, ein wärmehärtbarer Klebstoff verwendet wird.

4. Abbildungseinheit nach Anspruch 1, **dadurch gekennzeichnet, dass** die flexible Leiterplatte keine Klebstoffschicht zwischen einer Grundmatrix und einer Kupferschicht umfasst.

5. Abbildungseinheit nach Anspruch 1, wobei Einkerbungsbereiche (21) in dem Öffnungsbereich der flexiblen Leiterplatte ausgebildet sind.

6. Tragbares Endgerät, das durch die Anbringung einer Abbildungseinheit gemäß der Definition in Anspruch 1 **gekennzeichnet** ist.

## Revendications

1. Unité de formation d'image (100) montée sur un équipement terminal portable compact, **caractérisée en ce qu'**elle comprend :
(a) une carte de circuit imprimé souple (FPC) comportant une partie d'ouverture à une position prédéterminée ;
(b) un élément de formation d'image (2) qui est connecté, par une connexion par billes, à un côté de ladite carte de circuit de manière à recouvrir au moins une partie de la partie d'ouverture et à exposer une zone de formation d'image ;
(c) un élément de renfort (10) fixé à l'autre côté de ladite carte de circuit pour renforcer ladite carte de circuit ;
(d) un élément optique (1) qui est prévu pour guider une lumière d'objet d'une surface du côté élément de renfort jusqu'à la zone de formation d'image dudit élément de formation d'image à travers la partie d'ouverture ; et
(e) un élément de cadre externe (4) entourant ledit élément optique, **caractérisé en ce que** l'élément de renfort est constitué d'un matériau non métallique ayant un coefficient de dilation linéaire de 1 x 10⁻⁵ (cm/cm/°C) ou moins.

2. Unité de formation d'image selon la revendication 1, **caractérisée en ce que** l'élément de renfort consistant en ledit matériau non métallique est constitué de verre ou de céramique.

3. Unité de formation d'image selon la revendication 1, **caractérisée en ce que**, lorsque ledit élément de renfort doit être fixé à ladite carte de circuit imprimé souple, un adhésif thermodurcissable est utilisé.

4. Unité de formation d'image selon la revendication 1, **caractérisée en ce que** ladite carte de circuit imprimé souple ne comprend aucune couche adhésive entre une matrice de base et une couche de cuivre.

5. Unité d'image selon la revendication 1, dans laquelle des parties à encoche (21) sont crées dans la partie d'ouverture de ladite carte de circuit imprimé souple.

6. Equipement terminal portable, **caractérisé par** le montage d'une unité de formation d'image selon la revendication 1.
